# EUROPÄISCHE PATENTANMELDUNG

(11) **EP 2 846 462 A1**
(43) Veröffentlichungstag der Anmeldung: **11.03.2015**
(21) Anmeldenummer: 13182998.8
(22) Anmeldetag: 04.09.2013
(51) Int. Cl.: H03K 5/125, G06F 1/26, H02H 1/06

(54) **Verfahren zum Überwachen einer Stromversorgung**

(71) Anmelder: Siemens Aktiengesellschaft, 80333 München (DE)
(72) Erfinder: Schweigert, Harald, 1120 Wien (AT)
(74) Vertreter: Maier, Daniel Oliver

(57) **Zusammenfassung**

Die Erfindung betrifft ein Verfahren zur Überwachen einer Stromversorgung, welche über eine Signalleitung mit einer übergeordneten Steuerung verbunden ist, wobei mittels der übergeordneten Steuerung in variablen Abfrageintervallen abgefragt wird, ob die Stromversorgung fehlerfrei arbeitet. Dabei wird in einem fehlerfreien Betrieb dauerhaft ein sogenanntes Power-Good-Signal von der Stromversorgung über die Signalleitung an die übergeordnete Steuerung übermittelt und beim Auftreten eines Fehlers wird von der Stromversorgung über die Signalleitung ein Meldesignal (Sig) als Schaltfolge (4) von High/Low-Signalen an die übergeordnete Steuerung in der Weise übermittelt, dass jeder Signalwechsel der Schaltfolge (4) erst nach einer Zeitspanne erfolgt, welche länger ist als das größte zu erwartende Abfrageintervall und dass jedes Signal der Schaltfolge 4, welches nicht dem Power-Good-Signal entspricht, kürzer ist als eine vorgegebene Signaldauer zum Anzeigen eines Totalausfalls der Stromversorgung. Die übergeordnete Steuerung erhält somit mehr Informationen als dies bisher der Fall war.

## Beschreibung

Die Erfindung betrifft ein Verfahren zur Überwachen einer Stromversorgung, welche über eine Signalleitung mit einer übergeordneten Steuerung verbunden ist, wobei mittels der übergeordneten Steuerung in variablen Abfrageintervallen abgefragt wird, ob die Stromversorgung fehlerfrei arbeitet. Des Weiteren betrifft die Erfindung eine Anordnung zur Durchführung des Verfahrens.

In verschiedenen Anordnungen, welche Stromversorgungen umfassen, besteht der Bedarf, den Zustand der Stromversorgung zu überprüfen und einen Fehlerfall mittels einer übergeordneten Steuerung zu erfassen. Dies ist insbesondere bei Industrieanlagen der Fall, wo mehrere Stromversorgungen über Signalleitungen mit einer zentralen Anlagensteuerung verbunden sind. Durch die übergeordnete Überwachung wird eine fehlerhafte Stromversorgung oder eine die Stromversorgung angeschlossene fehlerhafte Last erkannt und es können rechtzeitig Maßnahmen ergriffen werden, um einen drohenden Ausfall eines Anlagenteils zu vermeiden.

Aus dem Stand der Technik kennt man ein Melderelais (z.B. VME421 der Firma Dipl.-Ing. W. Bender GmbH & Co KG) zur Überwachung von Stromversorgungen, wobei das Melderelais einen eigenen Komparator mit einer Referenz umfasst. Derart überwachte Stromversorgungen kommen beispielsweise zur Versorgung von Industriesteuerungen zum Einsatz. Des Weiteren kennt man Stromversorgungen mit integriertem Melderelais. Dabei weist die Stromversorgungen einen eigenen Komparator mit einer Referenz zu Ansteuerung des Melderelais auf. Das Melderelais signalisiert der übergeordneten Anlagensteuerung, dass die Ausgangsspannung unter einen vorbestimmten Wert gefallen ist. Ein Bedienpersonal der Anlagensteuerung kann daraus schließen, dass die mittels fehlerhafter Stromversorgung versorgten Anlagenteile (Relais, Schütze, Lichtschranken, Näherungsmelder etc.) der Anlage nicht mehr wie vorgesehen funktionieren oder keine verlässlichen Daten mehr liefern. Eine mögliche Reaktion kann ein geordnetes Abschalten der Anlage sein. Eine andere mögliche Reaktion ist das Umschalten auf redundant vorhandene Anlagenteile.

Das Melderelais wird dabei an einen sogenannten Digital-Eingang der übergeordneten Steuerung angelegt und mit einer Versorgungsspannung versehen. Die übergeordnete Steuerung ist in der Regel als steuerprogrammierbare Steuerung (SPS) ausgeführt und durchläuft zyklisch ein Steuerungsprogramm der Anlage. In jedem Programmdurchlauf wird jeder Digital-Eingang der SPS üblicherweise einmal abgefragt, wobei die Zykluszeiten abhängig von den aktuell durchzuführenden Steuerungs- und Auswertungsaufgaben variabel sein können.

Konkret erfolgt die Überwachung der Stromversorgung, indem die SPS den Signalzustand am Digital-Eingang, an dem das Melderelais angeschlossen ist, abfragt. Beispielsweise wird eine normale Ausgangsspannung mit einem High-Signal angezeigt, wohingegen ein Low-Signal anzeigt, dass die Ausgangsspannung unter einen vorgegebenen Schwellwert gefallen ist. Ein solches Überprüfungsverfahren erlaubt zwar die Nutzung eines einfachen Digital-Eingangs einer SPS, liefert aber keine differenzierte Zustandsinformation der Stromversorgung.

Aus der WO 2013/079110 A1 kennt man ein sogenanntes Selektivitätsmodul bzw. Diagnosemodul, welches zur Übermittlung eines Zustandssignals an eine übergeordnete Steuerung eingerichtet ist. Das Selektivitätsmodul umfasst dabei mehrere Kanäle zur parallelen Versorgungen unterschiedlicher Lasten. Das Zustandssignal beinhaltet die Information der einzelnen Kanalzustände in seriell kodierter Form. An einen digitalen Eingang der übergeordneten Steuerung wird während des Betriebs laufend eine Schaltfolge von High/Low-Signalen übermittelt.

Der Erfindung liegt die Aufgabe zugrunde, für ein Verfahren der eingangs genannten Art eine Verbesserung gegenüber dem Stand der Technik anzugeben.

Erfindungsgemäß wird diese Aufgabe gelöst durch die Merkmale der Ansprüche 1 und 21. Weiterbildungen sind in abhängigen Ansprüchen angeführt.

Dabei wird in einem fehlerfreien Betrieb dauerhaft ein sogenanntes Power-Good-Signal von der Stromversorgung über die Signalleitung an die übergeordnete Steuerung übermittelt und beim Auftreten eines Fehlers wird von der Stromversorgung über die Signalleitung ein Meldesignal als Schaltfolge von High/Low-Signalen an die übergeordnete Steuerung in der Weise übermittelt, dass jeder Signalwechsel der Schaltfolge erst nach einer Zeitspanne erfolgt, welche länger ist als das größte zu erwartende Abfrageintervall und dass jedes Signal der Schaltfolge 4, welches nicht dem Power-Good-Signal entspricht, kürzer ist als eine vorgegebene Low-Signaldauer zum Anzeigen eines Totalausfalls der Stromversorgung. Damit wird einerseits die Möglichkeit eröffnet, einem bestimmten Fehler eine charakteristische Schaltfolge von High/Low-Signalen zuzuordnen und andererseits wird ein Totalausfall der Stromversorgung zuverlässig erkannt, sobald eine Schaltfolge in ein fortdauerndes Low-Signal übergeht. Die übergeordnete Steuerung erhält somit mehr Informationen als dies bisher der Fall war. Im Normalzustand wird das Power-Good-Signal übermittelt, das zwangsläufig nur bei fehlerfreier Stromversorgung, fehlerfreier Last und fehlerfreier Signalleitung übertragen wird. Sobald ein Fehler auftritt, wird das Power-Good-Signal durch eine Schaltfolge von High-Low-Signalen unterbrochen. Gegenüber einer gewöhnlichen seriellen Übertragung besteht der Unterschied, dass die Signalwechsel der Schaltfolge in Zeitabständen erfolgen, die länger sind als die Zeitabschnitte zwischen den Abfragen der übergeordneten Steuerung. Erst dadurch ist es möglich, eine für die Abfrage von statischen Signalen ausgelegte Eingangsstufe wie einen Digital-Eingang zur Übermittlung zusätzlicher Informationen zu nutzen. Zudem ist ein robustes und auf dem Gebiet der Automatisierungstechnik verlässlich einsetzbares Relais zur Erzeugung des Meldesignals nutzbar, weil durch die dauerhafte Übermittlung eines Power-Good-Signals im Normalbetrieb keine laufenden Schaltwechsel erfolgen, welche sich negativ auf die Lebensdauer des Relais auswirken würden.

In einer vorteilhaften Ausführung wird als Power-Good-Signal ein High-Signal von der Stromversorgung über die Signalleitung an die übergeordnete Steuerung übermittelt. Bei einer solchen Ausführung ist keine Zusatzschaltung zur aktiven Übertragung eines Low-Signals notwendig. Ein High-Signal an einem Signalausgang der Stromversorgung wird über ein geeignetes Schaltelement (z.B. Relais) direkt an die übergeordnete Steuerung übertragen. Sobald die Stromversorgung ausfällt oder die Signalleitung unterbrochen wird, schaltet das High-Signal zwangsläufig auf ein Low-Signal um. Jedes Signal der Schaltfolge, welches nicht dem Power-Good-Signal entspricht, ist dann ein Low-Signal, für das eine Signaldauer zum Anzeigen eines Totalausfalls der Stromversorgung vorgegeben wird.

Von Vorteil ist es, wenn als größtes zu erwartendes Abfrageintervall eine längste zu erwartende Zykluszeit der als speicherprogrammierbare Steuerung ausgebildeten übergeordneten Steuerung vorgegeben wird. Die Nutzung einer SPS als übergeordnete Steuerung erlaubt somit eine einfache Festlegung der minimalen Zeitspanne zwischen den Signalwechseln der vorgesehenen Schaltfolge.

Im einfachsten Fall ist es vorteilhaft, wenn ein größtes zu erwartendes Abfrageintervall von 150ms vorgegeben wird. Damit ist bis auf vernachlässigbare Sonderfälle sichergestellt, dass die übergeordnete Steuerung einen Signalwechsel der Schaltfolge sicher erkennt.

In einer Ausprägung der Erfindung ist es von Vorteil, wenn jeder Signalwechsel der Schaltfolge erst nach einer Zeitspanne erfolgt, welche zumindest doppelt so lang ist als das größte zu erwartende Abfrageintervall. Damit ist das Abtasttheorem nach Fourier erfüllt, welches von einem beliebigen Signal mit einer beliebigen Frequenz ausgeht. Ein solches Signal wird dann eindeutig erkannt, wenn die Abtastfrequenz des Empfängers mindestens doppelten so hoch ist als die höchsten Frequenzanteile des empfangenen Signals.

In einer anderen Ausprägung der Erfindung ist vorgesehen, dass in der übergeordneten Steuerung jeder Zeitpunkt einer Abfrage gemeinsam mit dem Signalzustand des Meldesignals abgespeichert wird und dass aus einer Folge dieser abgespeicherten Werte und einem vorgegebenen fixen Takt des Meldesignals die übertragene Schaltfolge abgeleitet wird. Der fixe Takt des Meldesignals gibt dabei die kleinste mögliche Zeitspanne zwischen zwei Signalwechseln der Schaltfolge an, ohne dass zwingend mit jedem Takt ein Signalwechsel stattfindet. Der übergeordneten Steuerung ist auf diese Weise immer bekannt, wann ein Signalwechsel stattfinden könnte, nämlich mit jedem Takt des Meldesignals. Durch Überlagerung dieses Taktmusters mit dem zeitlichen Muster der abgespeicherten Signalzustände ist die tatsächliche Schaltfolge auf einfache Weise ableitbar. Es spielt dabei keine Rolle, ob während der Dauer eines gleichbleibenden Signalzustandes zu Beginn oder gegen Ende dieser Signalzustandsdauer abgefragt wird. Die Taktdauer des Meldesignals muss somit nur geringfügig länger sein als das größte zu erwartende Abfrageintervall der übergeordneten Steuerung.

Eine Weiterbildung des Verfahrens besteht darin, dass der Stromversorgung unterschiedliche Fehlerarten vorgegeben werden, dass jeder Fehlerart eine eigene Schaltfolge zugeordnet ist und dass beim Auftreten eines Fehlers die entsprechende Schaltfolge als fehlerspezifisches Meldesignal an die übergeordnete Steuerung übertragen wird. Das erlaubt eine differenzierte Analyse im Störungsfall, wobei auf unterschiedliche Fehler in geeigneter Weise reagiert wird. Fehlerarten, die nicht unmittelbar die grundlegende Funktionalität der Stromversorgung betreffen, führen dann nicht sofort zur Abschaltung der Stromversorgung sondern bewirken Wartungsmaßnahmen bei einer zukünftigen planmäßigen Überprüfung der Anlage.

Dabei ist es vorteilhaft, wenn der Stromversorgung für jede Fehlerart eine Prioritätsstufe vorgegeben wird und wenn bei gleichzeitig auftretenden Fehlern die Übermittlung der entsprechenden Schaltfolgen gemäß der zugeordneten Prioritätsstufe gereiht wird. Die Meldung von Fehlerarten, die eine Abschaltung der Stromversorgung erfordern, wird auf diese Weise nicht durch das gleichzeitige Auftreten unkritischer Fehler blockiert.

In diesem Zusammenhang ist es auch günstig, wenn beim Einschalten der Stromversorgung die Stromversorgung für jede Fehlerart eine jeweilige Kennung an die übergeordnete Steuerung übermittelt und wenn aus der jeweiligen Kennung die Prioritätsstufe und eine Wiederholungsvorgabe für eine mehrmalige Übermittlung der entsprechenden Schaltfolge hervorgehen. Damit wird nach einer Inbetriebnahme oder einer Einstellungsänderung der Stromversorgung die übergeordnete Steuerung zum ordnungsgemäßen Empfang verschiedener Schaltfolgen eingerichtet.

Eine Weiterbildung sieht vor, dass entsprechend einer Wiederholungsvorgabe eine erste Schaltfolge mehrmals hintereinander an die übergeordnete Steuerung übermittelt wird und dass diese wiederholte Übermittlung abgebrochen und eine zweite Schaltfolge übermittelt wird, falls ein neuer Fehler auftritt, dem die zweite Schaltfolge zugeordnet ist. Grundsätzlich dient die Wiederholung einer Schaltfolge zur verbesserten Erkennung dieser Schaltfolge. Sobald ein neuer Fehler auftritt, insbesondere einer mit höherer Priorität, wird die Wiederholung abgebrochen, um die neue und gegebenenfalls wichtigere Meldung zeitnahe an die übergeordnete Steuerung zu übermitteln.

Für die Vermeidung von Fehlmeldungen ist es von Vorteil, wenn der Stromversorgung eine Toleranzzeitspanne vorgegeben wird, wenn beim Auftreten eines Fehlers die Toleranzzeitspanne zu laufen beginnt und wenn bei andauerndem Fehler nach Ablauf der Toleranzzeitspanne die entsprechende Schaltfolge an die übergeordnete Steuerung übermittelt wird. Auf diese Weise ist sichergestellt, dass ein sehr kurzzeitiges Unter- oder Überschreiten eines Grenzwertes nicht sofort als Fehler gemeldet wird.

Von Vorteil ist es zudem, wenn für die Dauer einer fehlerhaften Ausgangsspannung ein Zeitlimit vorgegeben wird, nach dessen Ablauf eine gerade übermittelte Schaltfolge unterbrochen und stattdessen ein dauerhaftes Signal übermittelt wird, welches nicht dem Power-Good-Signal entspricht. Diese Maßnahme ist insbesondere bei einer Stromversorgung ohne separate Hilfsversorgung der Meldeelektronik sinnvoll, weil bei einem Totalausfall der Stromversorgung das Signal übermittelt wird, welches nicht dem Power-Good-Signal entspricht. Die übergeordnete Steuerung erkennt diesen Zustand als Meldung eines unveränderbaren Ausgangsspannungsfehlers und damit als Totalausfall der Stromversorgung. Dadurch wird sicher zwischen einer Signalübertragung mit mehreren Signalen in direkter Folge und einem Totalausfall der Stromversorgung unterschieden.

Eine weitere Verbesserung des Verfahrens sieht vor, dass bei bestimmten Fehlern die Stromversorgung abgeschaltet wird und dass die Stromversorgung nach einer neuerlichen Aktivierung eine entsprechende Schaltfolge an die übergeordnete Steuerung übermittelt. Damit ist sichergestellt, dass bei einer Notwendigkeit zur sofortigen Abschaltung der Stromversorgung nachträglich die Fehlerursache an die übergeordnete Steuerung gemeldet wird. Das kann bei einer plötzlichen Überhitzung der Stromversorgung der Fall sein, wobei eine Übermittlung einer Temperaturwarnmeldung nicht mehr vor der Abschaltung der Stromversorgung erfolgen kann. Durch die nachträgliche Fehlermeldung wird die Fehlersuche erleichtert.

Zur verbesserten Fehlersuche ist es auch sinnvoll, wenn in der übergeordneten Steuerung jede empfangene Schaltfolge, die als Fehlermeldung erkannt wird, mit einem Zeitstempel abgespeichert wird.

In einer einfachen Ausprägung des Verfahrens ist vorgesehen, dass zumindest eine Ausgangsspannung der Stromversorgung laufend überwacht wird und dass bei einem Einbruch der Ausgangsspannung in einem vorgegebenen Ausmaß über eine vorgegebenes Mindestzeit hinweg das zuvor dauerhaft übermittelte Power-Good-Signal beendet und die entsprechende Schaltfolge zur Anzeige des Ausgangsspannungseinbruchs an die übergeordnete Steuerung übermittelt wird.

Dabei ist es von Vorteil, wenn als Mindestzeit eine Zeitspanne vorgegeben wird, die länger als die längste zu erwartenden Ausregelungszeit der Stromversorgung nach einem Lastsprung ist. Lastsprünge treten bei der Zuschaltung oder Wegschaltung von Verbrauchern auf und sind insbesondere bei Industrieanlagen häufig. Eine resultierende Ausgangsspannungsänderung wird gewöhnlich durch die Stromversorgung ausgeregelt, ohne dass ein zu meldender Fehler vorliegt.

Ergänzend oder alternativ dazu ist vorgesehen, dass eine spezifische Temperatur der Stromversorgung laufend überwacht wird und dass bei Erreichung einer Grenztemperatur die entsprechende Schaltfolge zur Anzeige einer Temperaturüberschreitung an die übergeordnete Steuerung übermittelt wird.

Des Weiteren ist ergänzend oder alternativ dazu vorgesehen, dass ein Ausgangsstrom der Stromversorgung laufend überwacht wird und dass bei Erreichung eines Ausgangsstromschwellwertes die entsprechende Schaltfolge zur Anzeige einer Ausgangsstromüberschreitung an die übergeordnete Steuerung übermittelt wird.

Für eine verbesserte Erkennung von Meldesignalen durch die übergeordnete Steuerung ist es sinnvoll, wenn in der Stromversorgung vor einer aneinandergereihten Übermittlung von Schaltfolgen an die übergeordnete Steuerung überprüft wird, ob sich im Übergangsbereich zweier definierter Schaltfolgen zufällig eine andere definierte Schaltfolge ergibt und dass in diesem Fall zwischen den aneinandergereihten Schaltfolgen ein verlängertes Low-Signal oder ein verlängertes High-Signal übermittelt wird. Damit ist sichergestellt, dass nicht eine zufällig auftretende Schaltfolge fälschlicherweise als Fehlermeldung interpretiert wird.

Eine alternative Maßnahme sieht vor, dass in der Stromversorgung eine aneinandergereihte Übermittlung von Schaltfolgen an die übergeordnete Steuerung dahingehend überprüft wird, ob sich im Übergangsbereich zweier definierter Schaltfolgen zufällig eine andere definierte Schaltfolge ergibt und dass in diesem Fall zur Anzeige einer falschen Fehlermeldung eine eigens vordefinierte Schaltfolge an die übergeordnete Steuerung übermittelt wird.

Bei einer erfindungsgemäßen Anordnung zur Durchführung eines der genannten Verfahren ist der Eingang der übergeordneten Steuerung, an dem die Signalleitung anliegt, lediglich für eine Auswertung von High/Low-Signalen ausgelegt. Auf diese Weise ist eine übergeordnete Steuerung mit einer besonders einfach aufgebauten Schnittstelle zur Durchführung der genannten Verfahren verwendbar.

In einer vorteilhaften Ausprägung der Anordnung ist die Stromversorgung eine taktende Gleichstromversorgung, mit einem Ausgang zum Anschließen der Signalleitung. Solche Stromversorgungen sind besonders für die Versorgung von Verbrauchern in Industrieanlagen geeignet, wobei eine Meldung von Fehlern an eine übergeordnete Anlagensteuerung zur Erhaltung der Anlagenverfügbarkeit sinnvoll ist.

Dabei ist es günstig, wenn in der Stromversorgung eine eigene Meldeelektronik eingerichtet ist, welche an eine von der Ausgangsspannung der Stromversorgung unabhängige Hilfsversorgung angeschlossen ist. Damit ist sichergestellt, dass auch nach einer Abschaltung der Ausgangsspannung eine Meldung in Form von Schaltfolgen an die übergeordnete Steuerung erfolgt.

In einer anderen günstigen Ausführung ist vorgesehen, dass in der Stromversorgung eine eigene Meldeelektronik eingerichtet ist, welche über eine Pufferschaltung mit einem Energiespeicher an die Ausgangsspannung der Stromversorgung angeschlossen ist, sodass auch nach einer Abschaltung der Ausgangsspannung die Versorgung der Meldeelektronik mittels Energiespeicher gegeben ist. Als Energiespeicher steht beispielsweise eine Batterie oder ein Kondensator zur Verfügung, wodurch auch nach einem Ausfall der Ausgangsspannung ein Meldesignal an die übergeordnete Steuerung übertragbar ist.

Die Erfindung wird nachfolgend in beispielhafter Weise unter Bezugnahme auf die beigefügten Figuren erläutert. Es zeigen in schematischer Darstellung:
- Fig. 1: bekanntes Meldesignal einer Stromversorgung
- Fig. 2: Schaltfolge zur Meldung von Ausgangsspannungseinbrüchen
- Fig. 3: Struktur einer Schaltfolge
- Fig. 4: Beispielhafte Schaltfolgen

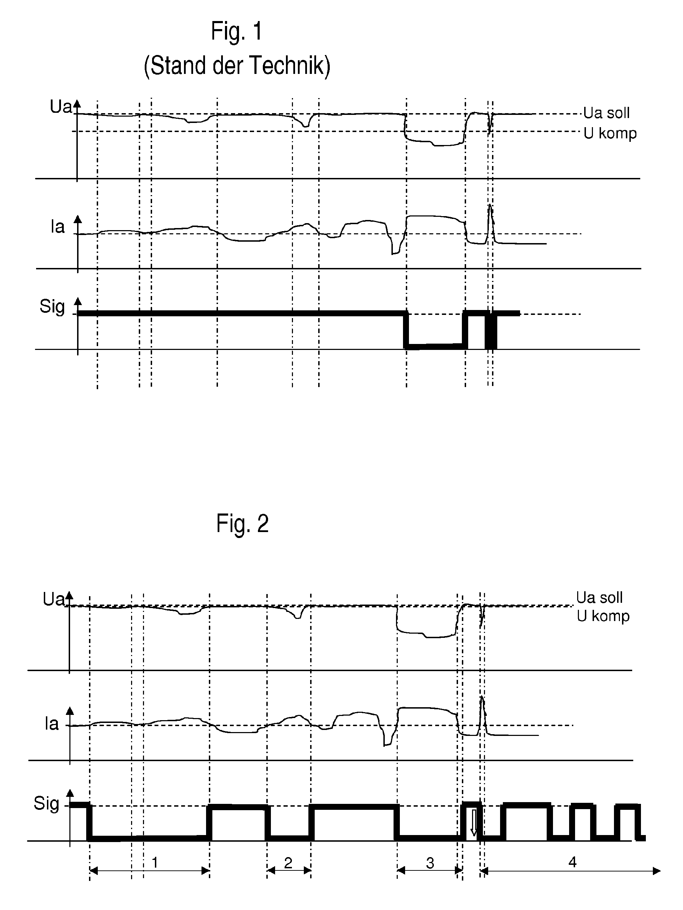

Bisherige Stromversorgungen signalisieren Ausgangsspannungseinbrüche mittels eines Meldesignals Sig, dass direkt aus der gemessenen Ausgangsspannung Ua abgeleitet wird (Fig. 1). Solange die Ausgangsspannung Ua einer Sollspannung Ua soll entspricht, wird ein High-Signal an eine übergeordnete Steuerung übermittelt. Wenn jedoch die Ausgangsspannung Ua unter einen Schwellwert U komp abfällt, wird das Meldesignals Sig auf ein Low-Signal umgeschaltet. Eine Strombegrenzung bewirkt, dass die Ausgangsspannung Ua absinkt, wenn der Ausgangsstrom Ia eine Stromgrenze überschreitet.

Wechselt ein solches Meldesignal nur für wenige Millisekunden in den Low-Zustand, ist die Erkennung vom Abfrageverhalten der übergeordneten Steuerung abhängig. Falls es sich bei der übergeordneten Steuerung um eine speicherprogrammierbare Steuerung mit einer variablen Zykluszeit handelt, erfolgt eine Abfrage des Einganges, an dem das Meldesignal anliegt, in der Regel nur einmal pro Zyklusdurchlauf. Dann bleibt es dem Zufall überlassen, ob während eines kurzzeitigen Low-Zustandes eine Abfrage erfolgt. Darüber hinaus ist mit einem solchen Meldesignal keine differenzierte Fehlerübertragung an die übergeordnete Steuerung möglich.

Um diese Nachteile zu überwinden, wird erfindungsgemäß ein Meldesignal als Schaltfolge von High/Low-Signalen an die übergeordnete Steuerung übermittelt. Dabei erfolgt jeder Signalwechsel der Schaltfolge erst nach einer Zeitspanne, welche länger ist als das größte zu erwartende Abfrageintervall. Zudem ist die Zeitspanne jedes Signals der Schaltfolge, welches nicht dem Power-Good-Signal entspricht, kürzer als eine vorgegebene Signaldauer zum Anzeigen eines Totalausfalls der Stromversorgung.

Damit ist die Möglichkeit geschaffen, alle Spannungseinbrüche 1, 2, 3 anzuzeigen, die länger anhalten als ein Abfrageintervall der übergeordneten Steuerung. Der Schwellwert U komp liegt dabei nur geringfügig unterhalb der Sollausgangsspannung Ua soll. Ein kürzerer Spannungseinbruch wird mit einer vordefinierten Schaltfolge 4 von High/Low-Signalen gemeldet (Fig. 2). Es erfolgt also eine Entkopplung des zeitlichen Verlaufs eines auftretenden Fehlers (z.B. Einbruch der Ausgangsspannung) und des Meldesignals Sig zur Übermittlung dieses Fehlers an die übergeordnete Steuerung.

Als Power-Good-Signal ist vorzugsweise ein High-Signal vorgegeben. Dabei übermittelt die Stromversorgung dieses Signal aktiv an die übergeordnete Steuerung, bis ein Fehler auftritt, der die Übermittlung einer Schaltfolge 4 bewirkt oder bis die Stromversorgung ausfällt oder bis die Signalleitung unterbrochen wird.

Alternativ dazu besteht die Möglichkeit, dem Signaleingang der übergeordneten Steuerung einen Pull-up-Widerstand vorzuschalten. Ein Relais zur Erzeugung der Schaltfolge 4 wird dann so geschaltet, dass bei erregter Spule das Meldesignal gegen Masse gezogen wird. Dann liegt als Power-Good-Signal am Eingang der übergeordneten Steuerung ein Low-Signal an.

Die Übermittlung erfolgt dabei entweder mittels eines elektrischen oder eines optischen Meldesignals Sig, wobei die Datenübertragung auf dem Power-Good-Signal beruht. Das bedeutet, dass im Normalfall an der übergeordneten Steuerung permanent ein aktives Signal anliegt. Nur zur Übermittlung eines Fehlers wird auf eine Schaltfolge umgeschaltet.

Beispielsweise dient ein Relais oder ein optisch getrennter Signal-Schalttransistor zur Übermittlung eines Schaltmusters. Als übergeordnete Steuerung ist zum Beispiel eine SPS vorgesehen. Ein wesentlicher Unterschied gegenüber einer bekannten seriellen Übermittlung besteht darin, dass die Umschaltung zwischen High- und Low-Signal in Zeitabständen erfolgt, die länger sind als die maximal zu erwartenden Programm-Durchlaufzeit (Zykluszeit) der SPS. Erst dadurch ist es möglich, eine für die Abfrage von statischen Signalen ausgelegte Eingangsstufe wie einen Digital-Eingang zur Übermittlung von zusätzlichen Informationen an die CPU der SPS zu nutzen.

Im einfachsten Fall erfolgt zur Anzeige eines Kurzeinbruchs der Ausgangsspannung Ua eine Verlängerung eines Low-Signals auf eine Zeitspanne, die großer ist als die Zykluszeit der SPS. Bei einem Kurzeinbruch der Ausgangsspannung von wenigen Millisekunden (z.B. 10ms) fällt das Relais dann z.B. für 200ms ab. Eine andere Möglichkeit besteht darin, eine Schaltfolge 4 von High-Low-Signalen an die SPS zu übermitteln (Fig. 2).

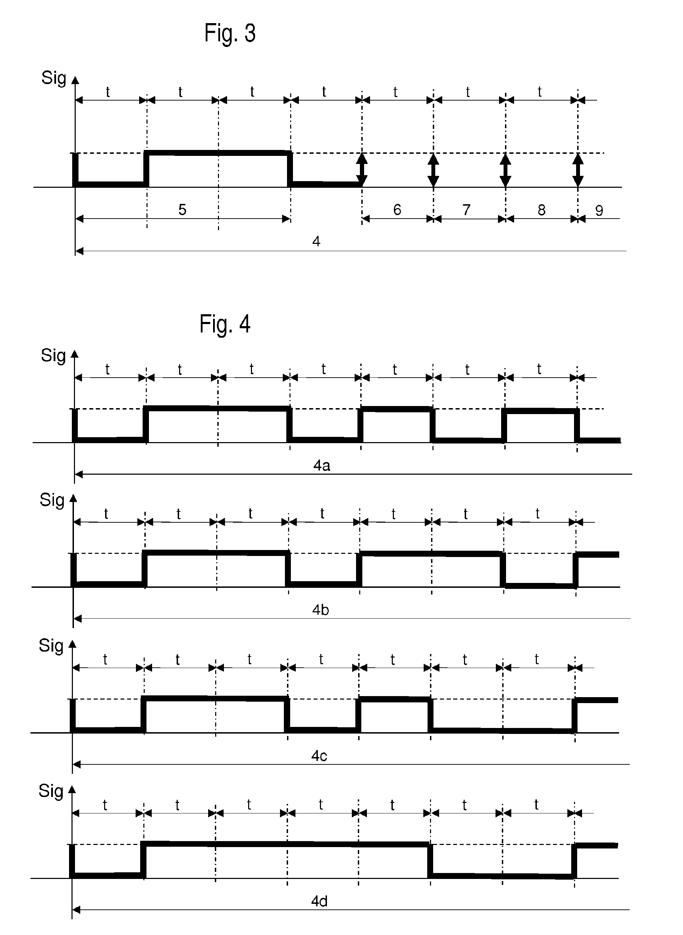

In Fig. 3 ist die Struktur eines differenzierten Meldesignals Sig dargestellt. Mit einem solchen Meldesignal Sig ist die Möglichkeit geschaffen, unterschiedliche Fehlerarten zu melden. Dabei werden Kriterien definiert, die einen Fehlerfall kennzeichnen. Die Ausgangsspannung Ua betreffend wird zum Beispiel eine Zeitspanne vorgegeben, welche größer ist als die Ausregelungszeit der Stromversorgung nach einem Lastsprung. Dazu wird ein Spannungssollwert Ua soll festgelegt. Ein Kriterium zur Meldung eines Fehlers ist dann erfüllt, wenn die Ausgangsspannung Ua über die vorgegebene Zeitspanne hinweg unter den Spannungssollwert Ua soll abfällt.

Ein weiteres beispielhaftes Kriterium besteht darin, dass die Ausgangsspannung Ua während einer weiteren Zeitspanne, welche die Ausregelungszeit der Stromversorgung übersteigt, um mehr als z.B. 30% unter den Spannungssollwert Ua soll abfällt. Damit wird eine massive kurzzeitige Überlast erfasst, welche durch einen zeitlich begrenzten Kurzschluss hervorgerufen wird. Die Meldung eines solchen Fehlers mittels einer entsprechenden Schaltfolge von High-Low-Signalen führt zu einem sofortigen Eingriff in die Anlagenfunktion.

Andere sinnvolle Kriterien sind Schwellenvorgaben für die Temperaturen kritischer Bauteile oder Kombinationen von Temperaturkriterien und Kriterien, welche die Ausgangsspannung Ua oder den Ausgangsstrom Ia der Stromversorgung betreffen.

Das Relais kennt nur die beiden Schaltzustände "Abfallen" und "Anziehen". In der Stromversorgung ist deshalb eine einfache Meldeelektronik zur Ansteuerung des Relais vorgesehen. Abhängig von der zu übertragenen Information wird das Relais gemäß einer vordefinierten Schaltfolge 4 angesteuert. Eine solche vordefinierte Schaltfolge 4 beginnt zum Beispiel mit einem Startbit 5, das aus einem Low-Signal von einer Taktlänge t und einem nachfolgenden High-Signal von zwei Taktlängen t besteht. Als Taktlänge t ist ein Zeitspanne vorgegeben, die länger ist als das größte zu erwartende Abfrageintervall (z.B. 250ms). Im Anschluss an das Startbit 5 folgt noch ein Low-Signal von einer Taktlänge t und dann stehen mehrere Bits 6, 7, 8, 9 zur Informationsübertragung zur Verfügung. Ein High-Signal entspricht der Binärzahl "1" und ein Low-Signal entspricht der Binärzahl "0". Mit z.B. vier aufeinanderfolgenden Bits 6, 7, 8, 9 sind sechzehn verschiedene Schaltfolgen 4 definierbar.

Sinnvoll ist eine Hierarchie von Fehlerarten, wobei die Meldungsübermittlung eines Fehlers unterbrochen wird, wenn ein Fehler mit einer höheren Priorität auftritt. Im einfachsten Fall ist diese wichtigere Meldung das völlige Fehlen der Ausgangsspannung Ua der Stromversorgung. Auch wenn die Versorgung des Relais nicht mehr gegeben ist und das Relais dauerhaft abfällt, wird dies von der SPS als Totalausfall der Stromversorgung erkannt. Ein dauerhaft abgefallenes Relais übermittelt somit eine höherwertige Information als ein Relais, welches noch in einer definierten Schaltfolge 4 schaltet.

Zur Absicherung der Meldungsübermittlung ist es sinnvoll, eine Schaltfolge 4 mehrmals hintereinander zu übermitteln, jedoch nicht fortlaufend, um die Lebensdauer des Relais nicht zu reduzieren. Für eine eindeutige Auswertung wird der SPS davor in Form einer Kennung die Wiederholungsvorgabe für jede Schaltfolge 4 übermittelt. Das geschieht z.B. nach jeder Inbetriebnahme oder Neueinstellung der Stromversorgung. Diese Kennungsübermittlung erfolgt ebenfalls in Form einer Schaltfolge von High-Low-Signalen, wobei zum Beispiel ein eigens für diesen Vorgang definiertes Startbit vorangestellt wird.

In Fig. 4 sind beispielhafte Schaltfolgen 4a, 4b, 4c, 4d dargestellt. Die ersten drei Schaltfolgen 4a, 4b, 4c weisen das gleiche Startbit auf und sind beispielsweise drei verschiedenen Fehlerarten zugeordnet. Die vierte Schaltfolge 4d mit einem anderen Startbit dient beispielsweise zur Anzeige einer Falschmeldung.

Die Erfindung umfasst auch Stromversorgungen mit mehreren Leistungsausgängen, wobei ein auftretender Fehler mit einer Zuordnung zum betroffenen Ausgang an die übergeordnete Steuerung übermittelt wird. Dies geschieht beispielsweise durch eine entsprechende Kennzeichnung des Ausgangs am Beginn oder am Ende einer Schaltfolge 4a, 4b, 4c.

## Patentansprüche

1. Verfahren zur Überwachen einer Stromversorgung, welche über eine Signalleitung mit einer übergeordneten Steuerung verbunden ist, wobei mittels der übergeordneten Steuerung in variablen Abfrageintervallen abgefragt wird, ob die Stromversorgung fehlerfrei arbeitet, **dadurch gekennzeichnet, dass** in einem fehlerfreien Betrieb dauerhaft ein sogenanntes Power-Good-Signal von der Stromversorgung über die Signalleitung an die übergeordnete Steuerung übermittelt wird und dass beim Auftreten eines Fehlers von der Stromversorgung über die Signalleitung ein Meldesignal (Sig) als Schaltfolge (4) von High/Low-Signalen an die übergeordnete Steuerung in der Weise übermittelt wird, dass jeder Signalwechsel der Schaltfolge (4) erst nach einer Zeitspanne erfolgt, welche länger ist als das größte zu erwartende Abfrageintervall und dass jedes Signal der Schaltfolge 4, welches nicht dem Power-Good-Signal entspricht, kürzer ist als eine vorgegebene Signaldauer zum Anzeigen eines Totalausfalls der Stromversorgung.

2. Verfahren nach Anspruch 1, **dadurch gekennzeichnet, dass** als Power-Good-Signal ein High-Signal von der Stromversorgung über die Signalleitung an die übergeordnete Steuerung übermittelt wird.

3. Verfahren nach Anspruch 1 oder 2, **dadurch gekennzeichnet, dass** als größtes zu erwartendes Abfrageintervall eine längste zu erwartende Zykluszeit der als speicherprogrammierbare Steuerung ausgebildeten übergeordneten Steuerung vorgegeben wird.

4. Verfahren nach einem der Ansprüche 1 bis 3, **dadurch gekennzeichnet, dass** ein größtes zu erwartendes Abfrageintervall von 150ms vorgegeben wird.

5. Verfahren nach einem der Ansprüche 1 bis 3, **dadurch gekennzeichnet, dass** jeder Signalwechsel der Schaltfolge (4) erst nach einer Zeitspanne erfolgt, welche zumindest doppelt so lang ist als das größte zu erwartende Abfrageintervall.

6. Verfahren nach Anspruch 1 oder 4, **dadurch gekennzeichnet, dass** in der übergeordneten Steuerung jeder Zeitpunkt einer Abfrage gemeinsam mit dem Signalzustand des Meldesignals (Sig) abgespeichert wird und dass aus einer Folge dieser abgespeicherten Werte und einem vorgegebenen fixen Takt des Meldesignals (Sig) die übertragene Schaltfolge (4) abgeleitet wird.

7. Verfahren nach einem der Ansprüche 1 bis 6, **dadurch gekennzeichnet, dass** der Stromversorgung unterschiedliche Fehlerarten vorgegeben werden, dass jeder Fehlerart eine eigene Schaltfolge (4) zugeordnet ist und dass beim Auftreten eines Fehlers die entsprechende Schaltfolge (4) als fehlerspezifisches Meldesignal an die übergeordnete Steuerung übertragen wird.

8. Verfahren nach Anspruch 7, **dadurch gekennzeichnet, dass** der Stromversorgung für jede Fehlerart eine Prioritätsstufe vorgegeben wird und dass bei gleichzeitig auftretenden Fehlern die Übermittlung der entsprechenden Schaltfolgen (4) gemäß der zugeordneten Prioritätsstufe gereiht wird.

9. Verfahren nach Anspruch 8, **dadurch gekennzeichnet, dass** beim Einschalten der Stromversorgung die Stromversorgung für jede Fehlerart eine jeweilige Kennung an die übergeordnete Steuerung übermittelt und dass aus der jeweiligen Kennung die Prioritätsstufe und eine Wiederholungsvorgabe für eine mehrmalige Übermittlung der entsprechenden Schaltfolge (4) hervorgehen.

10. Verfahren nach einem der Ansprüche 7 bis 9, **dadurch gekennzeichnet, dass** entsprechend einer Wiederholungsvorgabe eine erste Schaltfolge (4a) mehrmals hintereinander an die übergeordnete Steuerung übermittelt wird und dass diese wiederholte Übermittlung abgebrochen und eine zweite Schaltfolge (4b) übermittelt wird, falls ein neuer Fehler auftritt, dem die zweite Schaltfolge (4b) zugeordnet ist.

11. Verfahren nach einem der Ansprüche 1 bis 10, **dadurch gekennzeichnet, dass** der Stromversorgung eine Toleranzzeitspanne vorgegeben wird, dass beim Auftreten eines Fehlers die Toleranzzeitspanne zu laufen beginnt und dass bei andauerndem Fehler nach Ablauf der Toleranzzeitspanne die entsprechende Schaltfolge an die übergeordnete Steuerung übermittelt wird.

12. Verfahren nach einem der Ansprüche 1 bis 11, **dadurch gekennzeichnet, dass** für die Dauer einer fehlerhaften Ausgangsspannung ein Zeitlimit vorgegeben wird, nach dessen Ablauf eine gerade übermittelte Schaltfolge unterbrochen und stattdessen ein dauerhaftes Signal übermittelt wird, welches nicht dem Power-Good-Signal entspricht.

13. Verfahren nach einem der Ansprüche 1 bis 12, **dadurch gekennzeichnet, dass** bei bestimmten Fehlern die Stromversorgung abgeschaltet wird und dass die Stromversorgung nach einer neuerlichen Aktivierung eine entsprechende Schaltfolge (4) an die übergeordnete Steuerung übermittelt.

14. Verfahren nach einem der Ansprüche 1 bis 13, **dadurch gekennzeichnet, dass** in der übergeordneten Steuerung jede empfangene Schaltfolge (4), die als Fehlermeldung erkannt wird, mit einem Zeitstempel abgespeichert wird.

15. Verfahren nach einem der Ansprüche 1 bis 14, **dadurch gekennzeichnet, dass** zumindest eine Ausgangsspannung (Ua) der Stromversorgung laufend überwacht wird und dass bei einem Einbruch der Ausgangsspannung (Ua) in einem vorgegebenen Ausmaß über eine vorgegebene Mindestzeit hinweg die entsprechende Schaltfolge (4) zur Anzeige des Ausgangsspannungseinbruchs an die übergeordnete Steuerung übermittelt wird.

16. Verfahren nach Anspruch 15, **dadurch gekennzeichnet, dass** als Mindestzeit eine Zeitspanne vorgegeben wird, die länger als die längste zu erwartenden Ausregelungszeit der Stromversorgung nach einem Lastsprung ist.

17. Verfahren nach einem der Ansprüche 1 bis 16, **dadurch gekennzeichnet, dass** eine spezifische Temperatur der Stromversorgung laufend überwacht wird und dass bei Erreichung einer Grenztemperatur die entsprechende Schaltfolge (4) zur Anzeige einer Temperaturüberschreitung an die übergeordnete Steuerung übermittelt wird.

18. Verfahren nach einem der Ansprüche 1 bis 17, **dadurch gekennzeichnet, dass** ein Ausgangsstrom (Ia) der Stromversorgung laufend überwacht wird und dass bei Erreichung eines Ausgangsstromschwellwertes die entsprechende Schaltfolge (4) zur Anzeige einer Ausgangsstromüberschreitung an die übergeordnete Steuerung übermittelt wird.

19. Verfahren nach einem der Ansprüche 7 bis 18, **dadurch gekennzeichnet, dass** in der Stromversorgung vor einer aneinandergereihten Übermittlung von Schaltfolgen (4a, 4b) an die übergeordnete Steuerung überprüft wird, ob sich im Übergangsbereich zweier definierter Schaltfolgen (4a, 4b) zufällig eine andere definierte Schaltfolge (4c) ergibt und dass in diesem Fall zwischen den aneinandergereihten Schaltfolgen ein verlängertes Low-Signal oder ein verlängertes High-Signal übermittelt wird.

20. Verfahren nach einem der Ansprüche 7 bis 18, **dadurch gekennzeichnet, dass** in der Stromversorgung eine aneinandergereihte Übermittlung von Schaltfolgen (4a, 4b) an die übergeordnete Steuerung dahingehend überprüft wird, ob sich im Übergangsbereich zweier definierter Schaltfolgen (4a, 4b) zufällig eine andere definierte Schaltfolge (4c) ergibt und dass in diesem Fall zur Anzeige einer falschen Fehlermeldung eine eigens vordefinierte Schaltfolge (4d) an die übergeordnete Steuerung übermittelt wird.

21. Anordnung, welche zur Durchführung eines Verfahrens nach einem der Ansprüche 1 bis 20 eingerichtet ist, **dadurch gekennzeichnet, dass** der Eingang der übergeordneten Steuerung, an dem die Signalleitung anliegt, lediglich für eine Auswertung von High/Low-Signalen ausgelegt ist.

22. Anordnung nach Anspruch 21, **dadurch gekennzeichnet, dass** die Stromversorgung eine taktende Gleichstromversorgung ist, mit einem Ausgang zum Anschließen der Signalleitung.

23. Anordnung nach Anspruch 21 oder 22, **dadurch gekennzeichnet, dass** in der Stromversorgung eine eigene Meldeelektronik eingerichtet ist, welche an eine von der Ausgangsspannung (Ua) der Stromversorgung unabhängige Hilfsversorgung angeschlossen ist.

24. Anordnung nach Anspruch 21 oder 22, **dadurch gekennzeichnet, dass** in der Stromversorgung eine eigene Meldeelektronik eingerichtet ist, welche über eine Pufferschaltung mit einem Energiespeicher an die Ausgangsspannung der Stromversorgung angeschlossen ist, sodass auch nach einer Abschaltung der Ausgangsspannung die Versorgung der Meldeelektronik mittels Energiespeicher gegeben ist.
